# EUROPEAN PATENT APPLICATION

(11) **EP 3 168 863 A1**
(43) Date of publication of application: **17.05.2017**
(21) Application number: 15818335.0
(22) Date of filing: 07.07.2015
(51) Int. Cl.: H01L 21/027, B29C 33/38, B29C 59/02

(54) **MOLD FOR STEP-AND-REPEAT IMPRINTING, AND METHOD FOR PRODUCING SAME**

(30) Priority: 08.07.2014 JP 2014140932
(71) Applicant: Soken Chemical & Engineering Co., Ltd., Toshima-ku Tokyo 171-8531 (JP)
(72) Inventor: MIYAZAWA, Yukihiro, Sayama-shi Saitama 350-1320 (JP)
(74) Representative: Gulde & Partner
(86) International application number: PCT/JP2015/069485
(87) International publication number: WO 2016/006592

(57) **Abstract**

A step-and-repeat imprinting mold is provided that is capable of restraining deformation of an end of a convex and concave pattern formed in a cured resin layer when the mold is removed. According to the present invention, a step-and-repeat imprinting mold includes: a transparent base; a transparent resin layer formed thereon and having a pattern region formed with a convex and concave pattern; and a light shielding member provided between the transparent base and the transparent resin layer so as to overlap the pattern region in part of the pattern region.

## Description

### Technical Field

The present invention relates to a step-and-repeat imprinting mold and a manufacturing method thereof.

### Background Art

The imprinting technique is a micromachining technique in which a mold having a convex and concave pattern is pressed against a transfer material, such as a liquid resin, on a base, thereby transferring the mold pattern to the transfer material. Such a convex and concave micropattern ranges from patterns at the nanoscale, such as those at the 10 nm level, to patterns at approximately 100 µm. Such a technique is used in various fields, such as semiconductor materials, optical materials, recording media, micromachines, biotechnology, and environmental technology.

Molds having a convex and concave micropattern of nano order on a surface are very expensive because it takes time to form the pattern. Such molds having a convex and concave micropattern of nano order on a surface are thus difficult to be formed in a larger size (larger area).

PTL 1 enables imprinting in a large area by repeated imprinting using a small mold while moving the position of the mold not to overlap processing regions (step-and-repeat).

### Citation List

### Patent Literature

PTL 1: Japanese Patent No. 4262271

### Summary of Invention

### Technical Problem

In the method of PTL 1, a procedure of exposing a transfer material to light while a convex and concave pattern of a mold is pressed against the transfer material for curing to form a cured resin layer having a convex and concave pattern and then removing the mold from the cured resin layer is repeated. The present inventor has made detailed reviews on this method and has found that an end of the convex and concave pattern formed in the cured resin layer may be deformed when the mold is removed from the transfer material.

The present invention has been made in view of such circumstances and is to provide a step-and-repeat imprinting mold that is capable of restraining deformation of an end of a convex and concave pattern formed in a cured resin layer when the mold is removed.

### Solution to Problem

According to the present invention, a step-and-repeat imprinting mold is provided that includes: a transparent base; a transparent resin layer formed thereon and having a pattern region formed with a convex and concave pattern; and a light shielding member provided between the transparent base and the transparent resin layer so as to overlap the pattern region in part of the pattern region.

According to analysis by the present inventor, in the method of PTL 1, the region having a reverse pattern, formed by reversing the convex and concave pattern, formed in the transfer material and the region to cause the transfer material to be cured are approximately same. An excessive force thus applies to the reverse pattern at an end of the reverse pattern in the cured resin layer and the reverse pattern tends to be deformed. In the present invention, the light shielding member is provided to overlap the pattern region in part of the pattern region formed with the convex and concave pattern in the mold. The region to cause the transfer material to be cured is narrower than the region of the transfer material formed with the reverse pattern. The reverse pattern of an uncured resin layer is thus adjacent to an end of the reverse pattern in the cured resin layer, and the force applied to the end of the reverse pattern in the cured resin layer is reduced to restrain deformation of the reverse pattern in the cured resin layer.

Various embodiments of the present invention are disclosed below as examples. The following embodiments may be combined with each other.

Preferably, the pattern region is configured with a light transmissive region in which the convex and concave pattern is transferred to a transferred resin layer formed from a photocurable resin and then the transferred resin layer is cured by irradiation with an activation energy line; and a light shielding region in which the transferred resin layer is not cured even by irradiation with the activation energy line, the light shielding region being provided in a periphery of the light transmissive region.

Preferably, the transparent base has flexibility.

Preferably, the transparent base has a flat surface on a side formed with the transparent resin layer.

According to another aspect of the present invention, a method of manufacturing a step-and-repeat imprinting mold is provided that includes: placing a light shielding member in a predetermined position on a transparent base; forming a transparent resin layer having a pattern region formed with a convex and concave pattern on the transparent base to cover the light shielding member, wherein the light shielding member is provided to overlap the pattern region in part of the pattern region.

### Brief Description of Drawings

Fig. 1 is a cross sectional view illustrating a configuration of a step-and-repeat imprinting mold 2 in a first embodiment of the present invention.
Figs. 2A to 2D are cross sectional views illustrating a procedure of manufacturing the mold 2 in Fig. 1.
Figs. 3 to 3D are cross sectional views illustrating an imprinting method using the mold 2 in Fig. 1.
Fig. 4 is a cross sectional view illustrating a configuration of the step-and-repeat imprinting mold 2 in a second embodiment of the present invention.
Fig. 5 is a cross sectional view illustrating a configuration of the step-and-repeat imprinting mold 2 in a third embodiment of the present invention.
Fig. 6 is a cross sectional view illustrating a method of using the step-and-repeat imprinting mold 2 in the third embodiment of the present invention.

### Description of Embodiments

Preferred embodiments of the present invention are specifically described below with reference to the drawings.

### First Embodiment

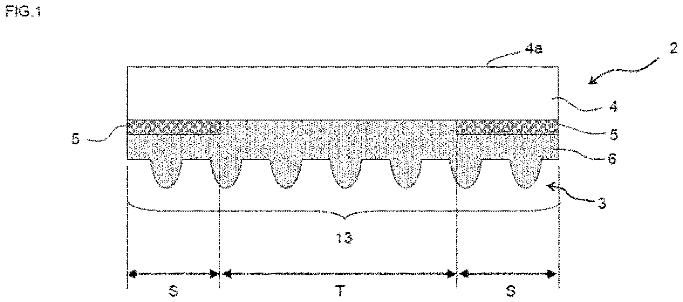

As illustrated in Fig. 1, a step-and-repeat imprinting mold 2 in the first embodiment of the present invention includes a transparent base 4, a transparent resin layer 6 formed thereon and having a pattern region 13 formed with a convex and concave pattern 3, and a light shielding member 5 provided between the transparent base 4 and the transparent resin layer 6 so as to overlap the convex and concave pattern 3 at an end of the pattern region 13.

Each component is described below in detail.

### 1. Configuration of Imprinting Mold 2

### (1) Transparent Base 4

The transparent base 4 is a base formed from a transparent material, such as a resin base, a quartz base, and a silicone base. A resin base is preferred to form a flexible resin mold and is specifically made of, for example, one selected from the group consisting of polyethylene terephthalate, polycarbonate, polyester, polyolefin, polyimide, polysulfone, polyether sulfone, cyclic polyolefin, and polyethylene naphthalate.

### (2) Transparent Resin Layer 6, Convex and Concave Pattern 3, and Pattern Region 13

The resin to form the transparent resin layer 6 may be any of a thermoplastic resin, a thermosetting resin, and a photocurable resin, and from the perspective of productivity and the ease of use as a mold, a photocurable resin is preferred. Specific examples include an acrylic resin, a styrene resin, an olefin resin, a polycarbonate resin, a polyester resin, an epoxy resin, a silicone resin, and the like. The resin may contain a peeling component, such as a fluorine compound, a long chain alkyl compound, and wax.

The above transparent resin layer 6 generally has a thickness ranging from 50 nm to 1 mm and preferably from 500 nm to 500 pm. A thickness in this range facilitates imprinting.

The convex and concave pattern 3 of the transparent resin layer 6 is not particularly limited. The pattern preferably has intervals from 10 nm to 2 mm, a depth from 10 nm to 500 µm, and a transfer surface from 1.0 to 1.0 × 106 mm2 and more preferably intervals from 20 nm to 20 µm, a depth from 50 nm to 1 µm, and a transfer surface from 1.0 to 0.25 × 106 mm2. Such settings enable sufficient transfer of the convex and concave pattern 3 to a transfer body. Specific shapes of the surface shape include moth eye patterns, lines, columns, monoliths, cones, polygonal pyramids, and microlens arrays.

The pattern region 13 formed with the convex and concave pattern 3 may be provided over the entire surface of the transparent base 4 or may be provided only in part of the transparent base 4.

The transparent resin layer 6 may have a surface subjected to peeling treatment to prevent adhesion to the transfer material, and the peeling treatment may form a peeling layer, not shown. A mold release agent to form the peeling layer, not shown, is preferably made of at least one selected from the group consisting of a fluorine-based silane coupling agent, a perfluoro compound having an amino group or a carboxyl group, and a perfluoroether compound having an amino group or a carboxyl group and more preferably at least one selected from the group consisting of a simple substance or a mixture of a simple substance and a complex of a fluorine-based silane coupling agent, a one-end aminated perfluoro (perfluoroether) compound, and a one-end carboxylated perfluoro (perfluoroether) compound. Use of the above substances as the mold release agent enables good close adhesion to the transparent resin layer 6 and good peelability from the resin for imprinting. The peeling layer, not shown, preferably has a thickness ranging from 0.5 to 20 nm, more preferably from 0.5 to 10 nm, and most preferably from 0.5 to 5 nm. To improve close adhesion between the peeling layer and the transparent resin layer 6, an additive having a group capable of bonding to the mold release agent as disclosed in WO2012/018045 may be added to the transparent resin layer 6.

### (3) Light Shielding Member 5

As illustrated in Fig. 1, the light shielding member 5 is provided between the transparent base 4 and the transparent resin layer 6 so as to overlap the pattern region 13 at an end of the pattern region 13.

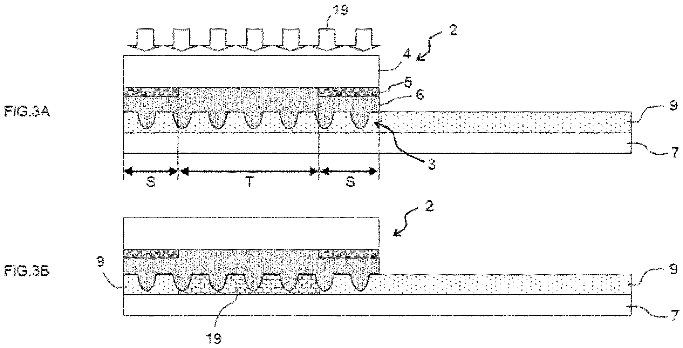

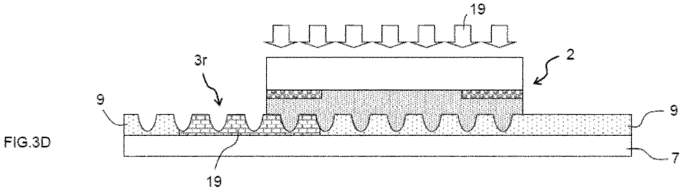

When the light shielding member 5 is formed over the convex and concave pattern 3 of the transparent resin layer 6, linearity of an end of a light shielding region S in which the light is shielded by the light shielding member 5 is sometimes not easily secured for the influence of the convex and concave pattern 3. According to the configuration of the present embodiment, it is possible to adhere the light shielding member 5 on the transparent base 4 and thus the linearity at the end of the light shielding region S is improved. As a result, the position accuracy of a light transmissive region T in which the light is not shielded by the light shielding member 5 is improved. When the light shielding member 5 is formed on a back side 4a of the transparent base 4, a distance between the light shielding member 5 and the convex and concave pattern 3 is long, and thus activation energy lines 19 (Fig. 3A and Fig. 3D) for irradiation in imprinting by step-and-repeat are prone to refract, diffract, and reflect between the light shielding member 5 and the convex and concave pattern 3. As a result, there is a problem of an increase in the amount of activation energy lines 19 reaching the light shielding region S. According to the configuration in the present embodiment, however, the distance between the light shielding member 5 and the convex and concave pattern 3 is very short, and the amount of activation energy lines 19 reaching the light shielding region S is thus minimized.

The method and material for forming the light shielding member 5 are not particularly limited as long as the purpose of shielding the activation energy lines is achieved. In an example, the light shielding member 5 may be formed by depositing a metal material, such as Cr, on the convex and concave pattern 3 by sputtering. The light shielding member 5 may be formed from an organic material, such as acrylic, urethane, and polycarbonate materials, or an inorganic material, such as carbon materials. These materials may contain other materials, such as pigments. The light shielding member 5 may be provided linearly along a side of the pattern region 13, may be provided in an L shape along two sides, may be provided along more sides, may be provided in a line, dot, or grid form, or may be provided along the entire perimeter of the pattern region 13.

Although a width to provide the light shielding member 5 is not particularly limited, the light shielding member 5 is preferably provided with in a region, for example, from 2 to 20% of the width of the pattern region 13. This is because a too narrow width of the light shielding member 5 causes a failure in obtaining an advantage of providing the light shielding member 5 and a too wide width of the light shielding member 5 reduces efficiency of imprinting.

The thickness of the light shielding member 5 is not particularly limited and should be a thickness to sufficiently restrain curing of the transfer material in the light shielding region S.

### 2. Method of Manufacturing Imprinting Mold 2

Next, a method of manufacturing the imprinting mold 2 is described.

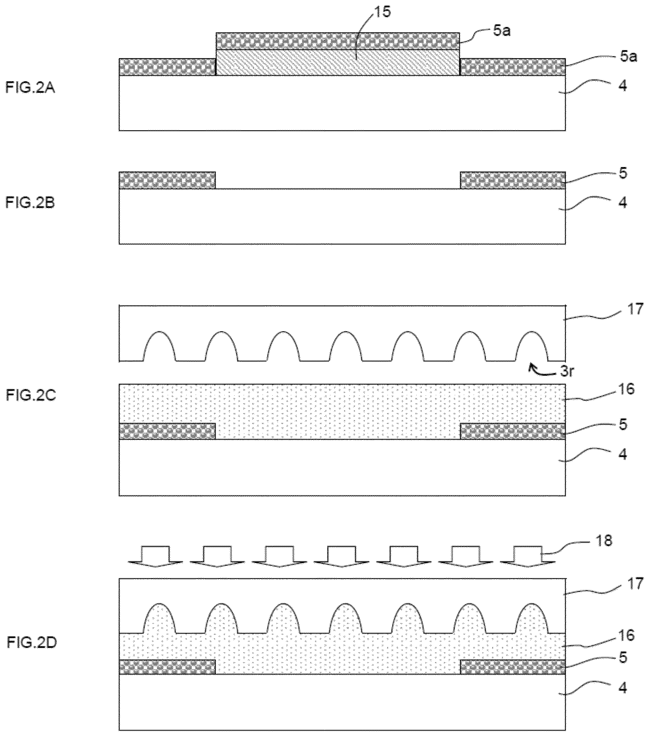

First, as illustrated in Fig. 2A, a resin layer 15 for lift-off process is formed in the light transmissive region T on the transparent base 4 using photolithography or the like, and then a metal material layer 5a is formed over the transparent base 4.

Next, as illustrated in Fig. 2B, the resin layer 15 and the metal material layer 5a thereon are removed to obtain a configuration provided with the light shielding member 5 on the transparent base 4. The light shielding member 5 may be formed by forming a resin layer in a predetermined position by, instead of lift-off process, a method such as photolithography, ink jet printing, and screen printing.

Then, as illustrated in Fig. 2C, a resin to form the transparent resin layer 6 is applied on the transparent base 4 to cover the light shielding member 5 and thus a transferred resin layer 16 is formed.

Then, as illustrated in Fig. 2D, the convex and concave pattern 3 is formed in the transferred resin layer 16 using a mold 17 having a reverse pattern 3r formed by reversing the convex and concave pattern 3. If the resin to form the transparent resin layer 6 is a thermoplastic resin, the mold 17 for forming the convex and concave pattern is kept at a pressing pressure from 0.5 to 50 MPa for 10 to 600 seconds while the transferred resin layer 16 is heated at a temperature of a glass transition temperature (Tg) or higher, and then the transferred resin layer 16 is cooled at a temperature of Tg or lower. The mold 17 is then separated apart from the transferred resin layer 16 to enable formation of the transparent resin layer 6 having the convex and concave pattern 3. Meanwhile, if the resin to form the transparent resin layer 6 is a photocurable resin, the transferred resin layer 16 is irradiated with activation energy lines (generic name for energy lines capable of curing a resin, such as UV light, visible light, and electron beams) 18 while the mold 17 for convex and concave pattern formation is pressed against the liquid transferred resin layer 16 to cure the transferred resin layer 16, and then the mold 17 is separated apart, thereby enabling formation of the transparent resin layer 6 having the convex and concave pattern 3. In this case, the mold 17 can be formed from a transparent material to irradiate the transferred resin layer 16 with the activation energy lines 18 through the mold 17. If the resin to form the transparent resin layer 6 is a thermosetting resin, the transferred resin layer 16 is heated to a curing temperature while the mold 17 for convex and concave pattern formation is pressed against the liquid transferred resin layer 16 to cure the transferred resin layer 16, and then the mold 17 is separated apart, thereby enabling formation of the transparent resin layer 6 having the convex and concave pattern 3.

### 3. Imprinting Method

Then, an imprinting method by a step-and-repeat method using the mold 2 is described.

First, as illustrated in Fig. 3A, a liquid photocurable resin is applied on a large area base 7 to form a transferred resin layer 9, and while the convex and concave pattern 3 of the mold 2 is pressed against a transferred resin layer 9, irradiation with the activation energy lines 19 is carried out through the transparent base 4. Irradiation with the activation energy lines 19 only in the light transmissive region T of the region for irradiation with the activation energy lines 19 cures the transferred resin layer 9 to form a cured resin layer 19 formed with the reverse pattern 3r. In the light shielding region S, the reverse pattern 3r is formed in the transferred resin layer 9 while the transferred resin layer 9 is not cured. Accordingly, in the state of Fig. 3B, the reverse pattern 3r formed in the cured resin layer 19 and the reverse pattern 3r formed in the transferred resin layer 9 are continuously formed.

Next, from the state of Fig. 3B, the mold 2 is removed. At this point, an excessive force applies to the reverse pattern 3r at an end of the reverse pattern 3r formed in the cured resin layer 19 and the reverse pattern 3r is prone to be deformed. In the present embodiment, however, the reverse pattern 3r is also formed in the uncured transferred resin layer 9 adjacent to the cured resin layer 19 and the force applied to the reverse pattern 3r in the cured resin layer 19 is thus reduced to restrain deformation of the reverse pattern 3r of the cured resin layer 19.

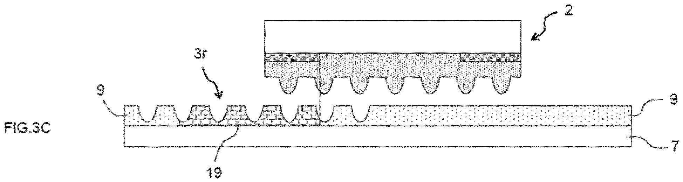

Then, as illustrated in Fig. 3C, the mold 2 is moved to the next processing region. As illustrated in Fig. 3C, the mold 2 is preferably moved to approximately match the position of boundary between the light shielding region S and the light transmissive region T with the position of boundary between the cured resin layer 19 and the transferred resin layer 9. In the position after movement, as illustrated in Fig. 3D, the convex and concave pattern 3 is transferred to the transferred resin layer 9 and the transferred resin layer 9 in the light transmissive region T is irradiated with the activation energy lines 19 to form the cured resin layer 19 formed with the reverse pattern 3r.

The above procedure is repeated in desired times to enable formation of a microstructure in desired size. Such a microstructure is applicable to imprinting molds, stampers for microcontact printing, optical sheets (antireflective sheets, hologram sheets, lens sheets, and polarization separation sheets), water repellent sheets, hydrophilic sheets, cell culture sheets, and the like.

### Second Embodiment

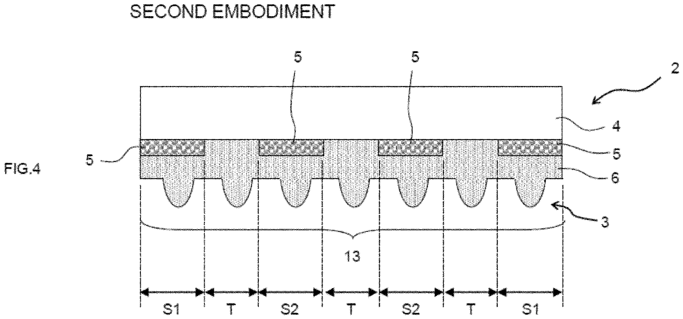

With reference to Fig. 4, the step-and-repeat imprinting mold 2 in the second embodiment of the present invention is described.

In the first embodiment, the light shielding member 5 is provided to overlap the pattern region 13 only at an end of the pattern region 13. In contrast, in the present embodiment as illustrated in Fig. 4, the light shielding member 5 is also provided in areas other than the end of the pattern region 13 in addition to the end of the pattern region 13. According to such a configuration, as illustrated in Fig. 4, a region covered with the light shielding member 5 provided at an end of the pattern region 13 is an end light shielding region S1, and regions covered with the light shielding member 5 provided other than the end of the pattern region 13 are non-end light shielding regions S2, and the remainder of the regions is the light transmissive region T. Even such a configuration is capable of restraining deformation of the reverse pattern 3r of the cured resin layer 19.

### Third Embodiment

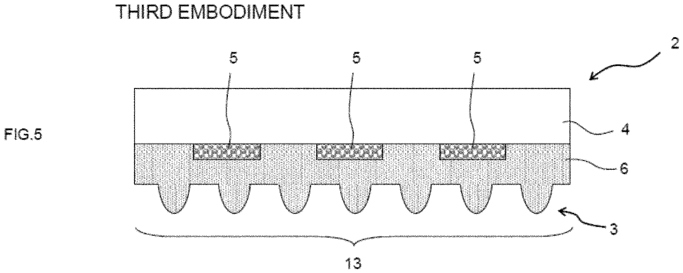

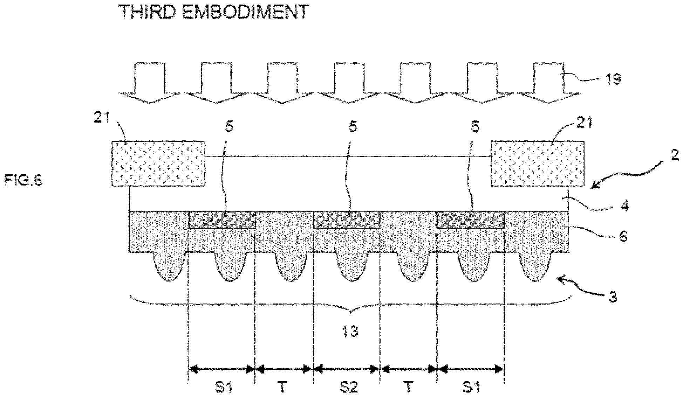

With reference to Figs. 5 and 6, the step-and-repeat imprinting mold 2 in the third embodiment of the present invention is described.

In the present embodiment, as illustrated in Fig. 5, the light shielding member 5 is not provided at an end of the pattern region 13 and is provided only in areas other than the end of the pattern region 13. The mold 2 of such a configuration may be used while, as illustrated in Fig. 6 for example, being kept by holding units 21 of the imprinting apparatus not to irradiate a region outside the light shielding member 5 with the activation energy lines 19. According to such a method of use, a region covered with the light shielding member 5 closest to the end of the pattern region 13 is the end light shielding region S1 and regions covered with the light shielding member 5 other than that are the non-end light shielding regions S2, and the reminder of the regions is the light transmissive region T. Accordingly, same as the second embodiment, it is possible to restrain deformation of the reverse pattern 3r in the cured resin layer 19.

The light shielding member 5 may be provided to overlap the pattern region in part of the pattern region 13 as in the present embodiment, and the position to provide the light shielding member 5 does not have to be an end of the pattern region 13.

### Reference Signs List

2: Imprinting Mold,
3: Convex and Concave Pattern,
4: Transparent Base,
5: Light Shielding Member,
6: Transparent Resin Layer,
7: Large Area Base,
9: Transferred Resin Layer,
21: Holding Unit

## Claims

1. A step-and-repeat imprinting mold comprising:
a transparent base;
a transparent resin layer formed thereon and having a pattern region formed with a convex and concave pattern; and
a light shielding member provided between the transparent base and the transparent resin layer so as to overlap the pattern region in part of the pattern region.

2. The mold of Claim 1, wherein the pattern region is configured with
a light transmissive region in which the convex and concave pattern is transferred to a transferred resin layer formed from a photocurable resin and then the transferred resin layer is cured by irradiation with an activation energy line; and
a light shielding region in which the transferred resin layer is not cured even by irradiation with the activation energy line, the light shielding region being provided in a periphery of the light transmissive region.

3. The mold of Claim 1 or 2, wherein the transparent base has flexibility.

4. The mold of any one of Claims 1 to 3, wherein the transparent base has a flat surface on a side formed with the transparent resin layer.

5. A method of manufacturing a step-and-repeat imprinting mold, comprising:
placing a light shielding member in a predetermined position on a transparent base;
forming a transparent resin layer having a pattern region formed with a convex and concave pattern on the transparent base to cover the light shielding member, wherein
the light shielding member is provided to overlap the pattern region in part of the pattern region.
